# EUROPEAN PATENT APPLICATION

(11) **EP 1 416 652 A1**
(43) Date of publication of application: **06.05.2004**
(21) Application number: 02360300.4
(22) Date of filing: 29.10.2002
(51) Int. Cl.: H04B 10/158, H03H 17/06, H03H 21/00

(54) **Adaptive electrical transversal filter with unipolar taps**

(71) Applicant: ALCATEL, 75008 Paris (FR)
(72) Inventor: Buchali, Fred, Dr., 71336 Waiblingen (DE)
(74) Representative: Rausch, Gabriele, Dr.

(57) **Abstract**

The invention relates to an electrical signal equaliser (SE) comprising a first transversal filter part (F1) with a chain of delay elements (D12- D14), individually adjustable signal weighting devices and a signal adding device (SU1), wherein the inputs of the weighting devices are each connected to one of said delay elements and the outputs are each connected to said adding device, wherein a signal splitting device (SP) is comprised connecting the first output to said first transversal filter part (F1) and connecting the other output to a second transversal filter part (F2), that a signal combining device (AD) is comprised connected to the outputs of the adding devices (SU1, SU2) of the two filter parts (F1, F2) and that signal inverting means are comprised for inverting the polarity of the output signals of one of said filter parts, an optical receiver and a method therefor.

## Description

The invention relates to an electrical signal equaliser comprising a first transversal filter part according to the preamble of claim 1, an optical receiver according to the preamble of claim 8 and a method according to the preamble of claim 11 therefore.

In data transmission systems, data is transported in form of electrical or optical signals, that are more or less affected by distortions or deformations during transmission, e.g. distortions due to a non linear behaviour of a transmission medium or distortions due to noise injected to the transmission medium. To avoid errors when recovering the data in a receiver, e.g. during the recovery of digital data in a decision circuit, reproduction of transmitted signals, i.e. a waveform correction of said signals is carried out, before the data is extracted or recovered in a decision circuit. Said reproduction is carried out by signal equalisers, they are connected between a signal input terminal and a decision circuit of a receiver.

Modern transmission systems are increasingly realised as optical transmission networks. The core of one of these optical networks is often realised as so-called wavelength division multiplex (WDM) transmission system. In WDM (transmission) systems, a certain number of modulated optical carriers with different frequencies, further named WDM-signals, are simultaneously transmitted in the optical waveguide. Each optical carrier thus constitutes an independent (wavelength) channel. In current commercial WDM systems executing a so-called dense wavelength-division multiplexing (DWDM), up to 40 channels are transmitted, each
channel having a transmission rate of up to 10 Gigabit per second (Gbit/s). The optical signals in such systems are affected by a wide rage of impairments. One important phenomenon, that particularly affects optical signals at high bit rates, i.e. signals showing a wide frequency spectrum, during transmission in an optical fibre is the so-called chromatic dispersion(CD). Further impairments are e.g. due to the polarisation mode dispersion (PMD) phenomenon, to WDM channel cross talk and to a non linear optical behaviour of optical amplifiers across an optical transmission line.

Methods of mitigation of impairments in the optical domain are well known in the prior art. The influence of the chromatic dispersion or of the polarisation mode dispersion e.g. can be compensated by pieces of dispersion compensating fibre of tuneable length switched at certain points into the transmission fibre. However, such devices are expensive and of large size and the adaptive control of such devices is complicated.

As an alternative or additional solution well known too, especially for lower data rates up to 10 Gbit/s, an equalisation after an opto-electrical conversion of the received optical signal and before the extraction of the data carried by said signal as described in the beginning can be advantageously applied.

For such an electronic equalisation of electrical signals, transversal filter structures showing finite response characteristics are preferably used. Such filters comprises a chain of delay circuits or buffers, wherein after each delay circuit, an electrical tap with a tuneable weighting means is provided, wherein the corresponding tapped signals are each individually weighed, further connected to an adding circuit for superimposing the tapped and weighted signals.

For serving as an adaptive signal equaliser, each tap of the described transversal filter must have bipolar tuneable weighting means, i.e. depending on a control signal, said taps must be able to weight a signal with positive or negative values. That leads to complex integrated circuits limiting the bit rate of a corresponding electrical signal.

The object of the invention is to describe an electrical signal equaliser and an optical receiver equipped with a corresponding signal equaliser, showing an alternative transversal filter structure, that only requires unipolar tuneable weighting means, i.e. a transversal filter structure comprising only taps, that are either able to weight a signal with solely positive tuneable values or are able to weight a signal with solely negative tuneable values.

This object is achieved in accordance with the invention by an electrical signal equaliser according to the teaching of claim 1, an optical receiver according to the teaching of claim 8, and a method according to the teaching of claim 11.

The invention proposes an electrical signal equaliser with a high speed transversal filter, wherein the data signal is divided into to branches. One branch with one number of delay elements is used for a realisation of positive tap values, the other branch with a further number of delay elements is used for a realisation of negative tap values. The signals are superimposed forming an equalised signal as output of said signal equaliser.

An advantageous further development of the invention consists in integrating said electrical signal equaliser in an optical receiver, wherein a received optical signal is converted into an electrical signal, that is fed to said electrical signal equaliser for generation of an equalised electrical signal to be fed to a decision gate.

Further developments of the invention can be gathered from the dependent claims and the following description.

In the following the invention will be explained further making reference to the attached drawings in which:
- Fig.1: shows an exemplary electrical signal equaliser according to the prior art,
- Fig.2: shows an exemplary electrical signal equaliser according to the invention and
- Fig.3: schematically shows an optical receiver according the invention.

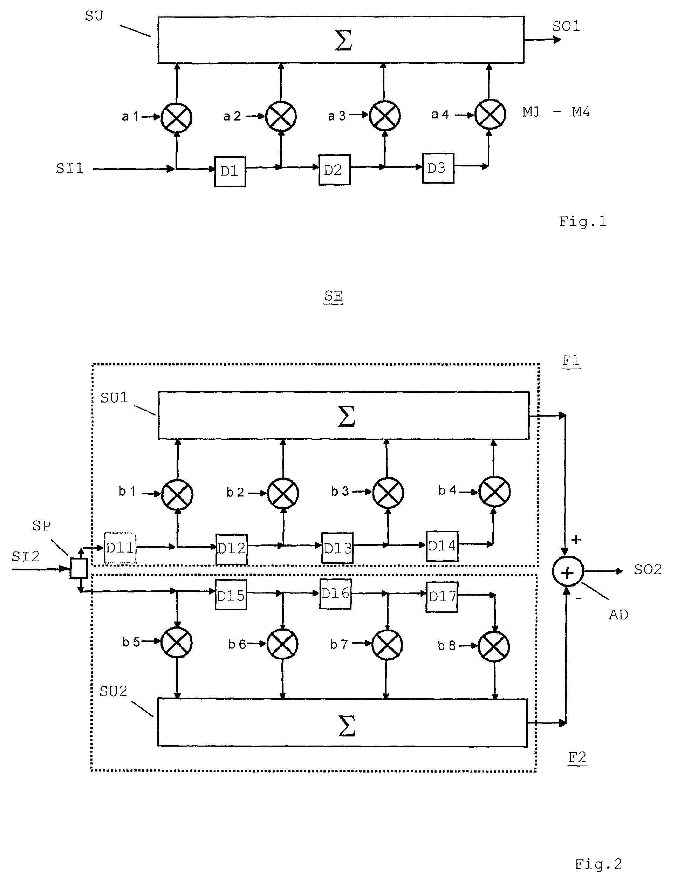

Fig.1 shows an exemplary electrical signal equaliser according to the prior art. Fig. 1 shows a transversal filter structure with, by way of example, a chain of three delay elements or buffers D1 -D3, connected in series. Further, four taps, one tap before the first delay element D1 and the other taps each behind one of the delay elements D1- D3, each comprising a signal multiplier M1- M4, are connected to a signal adder SU. To each of said multipliers M1- M4, each a first, a second, a third and a fourth weighting signal a1- a4 is fed.

A first input signal SI1 is fed to said chain of delay elements D1- D3. In the first tap, said first input signal SI1, not delayed, is weighted by multiplication with the first weighting signal a1. In the second tap, tapping the first input signal, delayed by the first delay element D1, is weighted by multiplication with the second weighting signal a2. In the third tap, tapping said first input signal SI1, delayed by the first delay element D1 and the second delay element D2, is weighted by multiplication with the third weighting signal a3. In the fourth tap, tapping said first input signal SI1, delayed by the first delay element D1, the second delay element D2 and the third delay element D3, is weighted by multiplication with the fourth weighting signal a4. The individually delayed and weighted signal parts are superimposed in the signal adder SU, that generates a first output signal S01. Often, the delay time of the delay elements D1- D3 is each equal to the so-called bit slot time T, i.e. to the time duration of one information element within the first input signal SI1.

Transversal filters as shown in Fig.1, having a finite response time, are well known in the field of electrical signal (waveform) equalisation. Distortions and disturbances during transmission of an electrical signal as well as of an optical signal are varying with the time. A corresponding equaliser need to be adapted to said distortions and disturbances. Therefore, e.g. the waveform of a received signal is measured and/or the bit error rate is observed at receivers side and, in case of waveform degradations or an increased bit error rate, the corresponding filter is adapted for compensating said disturbances and distortions. The adaptation of the filter shown in Fig. 1 is carried out by adjusting the weighting signals a1- a4. Normally, said weighting signals can vary in a defined rage between a maximum positive and a maximum negative value. Therefore, the signal multipliers M1- M4 must be bipolar. The realisation of a high speed transversal filter, i.e. a transversal filter capable to equalise a signal showing a bit rate of 10 Gbit/s or more, comprising bipolar multipliers leads to a complex integrated circuit. Moreover, the limits of the corresponding microelectronic circuit might prevent said filter from a usage for bit rates of 40 Gbit/s and above.

To overcome said problems, an exemplary electrical signal equaliser according to the invention is shown in Fig.2. Fig.2 shows an electrical signal equaliser SE showing a transversal filter structure comprising two filter parts F1 and F2, wherein each of said filter parts F1 and F2 show the same structure as the equaliser shown in Fig.1, with the only difference, that an optional additional delay element D11 is added to the first filter part F1. In said first filter part F1, the additional delay elements D11 connected before the chain of other delay elements, denoted as delay elements D12-D14. The corresponding weighting signals are denoted as weighting signals b1- b4. In said second filter part, the delay elements are denoted as D15-D17 and the corresponding weighting signals are denoted as weighting signals b5- b8. a second input signal SI2 is fed to a signal splitter SP, that connects to each the additional delay element D11 of first filter part F1 and to the first tap of the second filter part F2. The signal adder of the first filter part is denoted as first signal adder SU1 and the signal adder of the second filter part is denoted as second signal adder SU2. The outputs of said first and second signal adders SU1 and SU2 are connected to a signal combining device AD, generates a differential output signal SO2 out of the received signals.

The delay time of the delay elements D12- D17, similar to the delay elements shown in Fig.1, is each equal to the so-called bit slot time T or a fraction of that time T of the second input signal SI2. The delay time of the additional delay element D11 delay time preferably amounts to the half of said delay time of the delay elements D12-D17.

The advantage of the filter structure shown in Fig.2 is, that the taps only needs to be unipolar, i.e. need to carry out either a positive weighting or a negative weighting. In the example shown in Fig.2, it is assumed, that as well as the taps in the first filter part F1, controlled by the weighting signals b1- b4, as also the taps in the second filter part F2, controlled by the weighting signals b5- b8, carry out positive weightings of the correspondingly delayed second input signal SI2. As the output signal of the second filter part is inverted before they are added to the output signal of the first filter part F1 by the signal combining device AD, the weighting within the second filter part is negative as a whole. Alternatively, instead of inverting said signal before adding to the signal of the first filter part, the input signal to the second filter part is inverted. In a further alternative, instead of inverting the input signal to or the output signal from said second filter part, the tabs in the first filter part F1, controlled by the weighting signals b1- b4, carry out positive weightings and that the tabs in the second filter part F2, controlled by the weighting signals b5- b8, carry out negative weightings.

Without the additional delay element D11, by correctly adjusting the weighting signals b1-b8, it is possible to achieve a transfer function of the electrical signal equaliser according to the invention similar to the transfer function of any transversal equaliser according to the prior art as depicted in Fig.1 with arbitrary negative or positive weighting signals a1- a4.

If the signal weighting is performed only in the range between 0 and 1, the weighting means can be realised as signal attenuators instead of signal multipliers.

Alternatively, if the weighting range is between 0 and any positive value, the weighting means can be realised as variable unipolar amplifiers.

For many equalising tasks, the weighting of a transversal equaliser has to be carried out with alternating polarity of each two adjacent equidistantly delayed tapped signals. For a realisation according to the invention, the additional delay element D11 performs a delay of T/2 between both filter parts F1 and F2. This allows for doubling of the tap number of any filter with alternating taps.

If the delay time of said additional delay element D11 is set to 0, the pairs of corresponding unipolar taps form each one bipolar tap. Differently to the example described above, the sampling time is not doubled, but each tap can be arbitrarily tuned to any value (in a certain range covering positive and negative values).

Instead of any signal inversion described before, the output signal of the first filter part F1 is fed to a first input (DATA input) and the non-inverted output signal of the second filter part F2 is fed to a second input (inverted DATA input) of the signal combining device AD, that is realised as differential decision gate. For this alternative, no superposition of both said signals is necessary. However a superposition as described before leads to a bandwidth reduction.

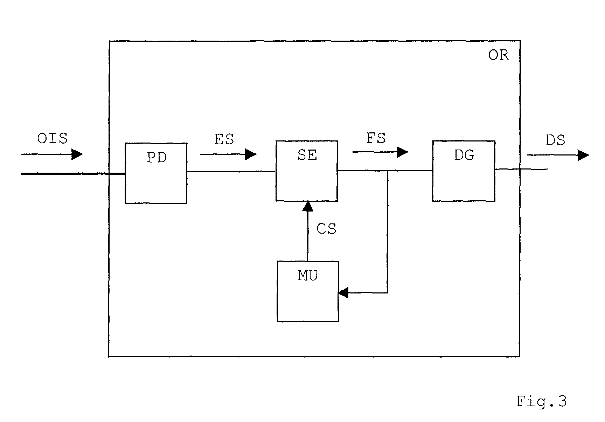

Fig.3 now schematically shows an optical receiver OR according the invention. The optical receiver further comprises an opto-electrical converter PD, an electrical signal equaliser SE according to the invention and a decision gate DG connected in series. An optical input signal OIS is fed to the optical input of the opto-electrical converter PD. The electrical output signal ES of said opto-electrical converter PD is fed to the input of said signal equaliser SE. The output signal FS of said signal equaliser SE is fed to a monitoring unit MU and to the decision gate DG, that generates a digital information IS. Further, a control signal CS is fed from the monitoring unit to said signal equaliser SE.

The opto-electrical converter PD might be realised as photo diode with mostly linear behaviour, i.e. generating an electrical ES of similar shape according to the optical input signal OIS. The waveform of said electrical signal ES, that e.g. shows a so-called amplitude shift keying modulation, is monitored by the monitoring unit MU.

Said monitoring unit MU compares the waveform of the received signal with the desired waveform and generates a control signal CS to compensate for the deformation of the signal in the signal equaliser SE. A control signal CS according to the example of Fig.2 comprises the weighting signals or values b1- b8. The equalised or rectified output signal of said signal equaliser FS is now fed to a decision gate DG known form the prior art, that periodically according to the bit slot time T, detects the bit information carried by the received signal OIS.

The electrical signal equaliser SE comprises a splitter SP, and two transversal filter parts F1 and F2 as described under Fig.2. Alternatively, the splitting for distributing a signal to each of said filter parts F1 or F2 is realised by means of an optical splitter and that the opto-electrical signal converting is realised by means of two individual opto-electrical signal converters, wherein each output of said optical splitter is connected to one of said individual opto-electrical signal converters, that are further connected to the filter part F1 or F2 respectively.

The signal inverter can be integrated within the signal combining device (AD) that is therefore realised as differential decision circuit providing a differential input therefore.

## Claims

1. An electrical signal equaliser (SE) comprising a first transversal filter part (F1) with a chain of delay elements (D12- D14), individually adjustable signal weighting devices and a signal adding device (SU1), wherein the inputs of the weighting devices are each connected to one of said delay elements and the outputs are each connected to said adding device, **characterised in, that** a signal splitting device (SP) is comprised connecting the first output to said first transversal filter part (F1) and connecting the other output to a second transversal filter part (F2), that a signal combining device (AD) is comprised connected to the outputs of the adding devices (SU1, SU2) of the two filter parts (F1, F2) and that signal inverting means are comprised for inverting the polarity of the output signals of one of said filter parts.

2. An electrical signal equaliser (SE) according to claim 1, **characterised in, that** the signal inverting means are realised as a signal inverter, that is connected into the line before or after the second filter part (F2).

3. An electrical signal equaliser (SE) according to claim 2, **characterised in, that** the signal inverter is integrated within the signal combining device (AD) that is therefore realised as differential decision circuit.

4. An electrical signal equaliser (SE) according to claim 2, **characterised in, that** the signal weighting means are realised as signal attenuators.

5. An electrical signal equaliser (SE) according to claim 2, **characterised in, that** the signal weighting means are realised as variable amplifiers.

6. An electrical signal equaliser (SE) according to claim 1, **characterised in, that** the signal inverting means of the second filter part are realised such, that weighting means in the first filter part perform each a positive weighting and the weighting means in the second filter part perform each a negative weighting.

7. An electrical signal equaliser (SE) according to claim 1, **characterised in, that** a monitoring unit (MU) for detection of signal waveform form deviations is comprised that is adapted to generate control signals (b1- b8) for control of the signal weighting means.

8. An optical receiver (OR) with opto-electrical signal converter means and an electrical signal equaliser (SE), **characterised in, that**
• the electrical signal equaliser (SE) comprises two transversal filter parts (F1, F2) with each a number of delay elements (D12- D14, D15- D17), individually adjustable signal weighting devices and a signal adding device (SU1, SU2), wherein each the inputs of the weighting devices are each connected to one of said delay elements (D12- D14, D15- D17), and the outputs are each connected to one of said adding devices (SU1, SU2),
• a signal splitting device (SP) is comprised for providing said two transversal filter parts (F1, F2) with each an individual signal,
• a signal combining device (AD) is comprised connected to the outputs of the adding devices (SU1, SU2) of the two filter parts (F1, F2) and
• signal inverting means are comprised for inverting the polarity of the output signal of one of said filter parts (F1, F2).

9. An optical receiver (OR) according to claim 8, **characterised in, that** the splitting means (SP) are realised as electrical splitter and that the opto-electrical signal converter means (SP) are realised as a unique opto-electrical signal converter, wherein said opto-electrical signal converter is connected before the electrical splitter (SP).

10. An optical receiver (OR) according to claim 8, **characterised in, that** the splitting means (SP) are realised as an optical splitter and that the opto-electrical signal converter means (PD) are realised as two individual opto-electrical signal converters, wherein each output of said optical splitter is connected to one of said individual opto-electrical signal converters, that are each further connected to one of said filter parts (F1, F2).

11. A method for equalising an electrical input signal (SI2), wherein said signal is fed to a first transversal filter part (F1) with a number of delay elements (D12-D14) to obtain a number of differently delayed signals, wherein said differently delayed signals are individually weighted and added after being weighted to generate a first output signal, **characterised in, that**
• an identical input signal is fed to a second filter part (F2) of similar structure according to the structure of the first filter part (F1) for generating a second output signal,
• in both filter parts (F1, F2), only unipolar weightings are performed and
• the first and the second output signals are combined in a differential way for further processing in a decision circuit.
